# EUROPÄISCHE PATENTANMELDUNG

(11) **EP 1 211 724 A2**
(43) Veröffentlichungstag der Anmeldung: **05.06.2002**
(21) Anmeldenummer: 01125065.1
(22) Anmeldetag: 22.10.2001
(51) Int. Cl.: H01L 21/66

(54) **Verfahren zum automatischen Überwachen der Herstellung von integrierten Schaltkreisen abhängig von der Anzahl ausgeführter Bearbeitungsschritte, zugehörige Einheiten und zugehöriges Programm**

(30) Priorität: 01.12.2000 DE 10059908
(71) Anmelder: Infineon Technologies AG, 81669 München (DE)
(72) Erfinder: Steinkirchner, Erwin, 94315 Straubing (DE); Maeritz, Jörn, 93152 Zeiler/Nittendorf (DE)
(74) Vertreter: Kindermann, Peter, Dipl.-Ing.

(57) **Zusammenfassung**

Erläutert wird ein Verfahren, bei dem die Sollanzahl von gleichartigen Bearbeitungsschritten für einen Bearbeitungszyklus vorgegeben wird. Die Istanzahl der in einem Bezugsarbeitszyklus ausgeführten Bearbeitungsschritte wird automatisch erfasst. Weiterhin wird die Istanzahl der in einem dem Bezugsarbeitszyklus folgenden Arbeitszyklus ausgeführten Bearbeitungsschritte automatisch erfasst. Abhängig von den so ermittelten Mistanzahlwerten wird eine automatische Prüfung auf Fertigungsfehler bzw. Bedienfehler ausgeführt.

## Beschreibung

Die Erfindung betrifft ein Verfahren, bei dem die Sollanzahl von Bearbeitungsschritten für einen Bearbeitungszyklus vorgegeben wird. In einem Bearbeitungszyklus wird ein Halbzeug bearbeitet oder geprüft, aus dem mehrere integrierte Schaltkreise gefertigt werden sollen. In der Regel sind die Bearbeitungsschritte gleich, weil gleich aufgebaute Schaltkreise auf einem Halbzeug hergestellt werden.

Ein Bearbeitungszyklus wird durch die Zeit festgelegt, in der die eingesetzte Fertigungsanlage ohne Unterbrechung an einem Halbzeug arbeitet. Mit der Bearbeitung des nächsten Halbzeuges beginnt ein neuer Bearbeitungszyklus. Ein Bearbeitungszyklus ist auch beendet, wenn er vor dem Erreichen der Sollanzahl abgebrochen wird. In diesem Fall muss für dasselbe Halbzeug ein weiterer Bearbeitungszyklus gestartet werden, um die noch verbliebenen Bearbeitungsschritte auszuführen.

Bei der Herstellung eines integrierten Schaltkreises durchläuft ein Halbzeug eine Vielzahl von Prozessstufen, z.B. etwa 200. Als Halbzeug werden Beispielsweise Siliziumscheiben eingesetzt, die während der Herstellung der integrierten Schaltkreise mehrfach beschichtet, mit Fotolack überzogen, belichtet, entwickelt, geätzt und geprüft werden müssen. Insbesondere beim Belichten und beim Prüfen werden eine Vielzahl von gleichartigen Bearbeitungsschritten pro Siliziumscheibe und pro Bearbeitungszyklus ausgeführt.

So wird beim Belichten jeweils nur ein Teilbereich der Siliziumscheibe belichtet, der für eine oder mehrere integrierte Schaltkreise vorgesehen ist. Zur Ausführung von Belichtungen werden Belichtungsanlagen, wie z.B. sogenannte Stepper, sogenannte Step- und Scan-Systeme sowie sogenannte Scanner eingesetzt.

Aus unterschiedlichen Gründen, z.B. Stromausfall oder ein Anlagenfehler, kann es an der die Bearbeitung ausführenden Anlage zu Fertigungsunterbrechungen kommen. In solchen Fällen muss eine Bedienperson die Anlage wieder in Betrieb nehmen und die Bearbeitung eines nur teilweise bearbeiteten Halbzeuges fortsetzen. Bei der Wiederinbetriebnahme kommt es unter Umständen zu Bedienfehlern. Werden die Bedienfehler nicht oder zu spät erkannt, so sinkt die Ausbeute und nachfolgende Bearbeitungsschritte werden unnötigerweise ausgeführt.

Die Bedienpersonen müssen oft mehrere Anlagen bedienen, so dass auch bei sehr konzentrierter Arbeit Fertigungsfehler durch Fehlbedienungen nicht vermeidbar sind. Bisher lassen sich solche Fehler nur durch eine vollständige Kontrolle aller bearbeiteter Halbzeuge ein einfaches Verfahren erfassen, z.B. mit Hilfe von Verfahren der Bildbearbeitung.

Es ist Aufgabe der Erfindung, zum automatischen Überwachen der Herstellung von integrierten Schaltkreisen ein einfaches Verfahren anzugeben, mit dessen Hilfe insbesondere eine hohe Ausbeute erzielt wird und mit dessen Hilfe insbesondere Bedienfehler schnell erfasst werden können. Außerdem sollen ein zugehöriges Programm, eine zugehörige Datenverarbeitungsanlage und eine zugehörige Bearbeitungsanlage zur Herstellung von integrierten Schaltkreisen angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Die Erfindung geht von der Überlegung aus, dass typische Bedienfehler zu einer Anzahl von Bearbeitungsschritten pro Halbzeugen führen, die von der Sollanzahl abweicht. Es werden entweder zu viele Bearbeitungsschritte ausgeführt, d.h. ein Teil des Halbzeuges wird doppelt bearbeitet, oder es werden zu wenige Bearbeitungsschritte ausgeführt, d.h. ein Teil des Halbzeuges wird nicht bearbeitet. Beispielsweise kommt es bei der Wiederinbetriebnahme einer Belichtungsanlage durch das Vertauschen der Reihen und Spaltennummer einer Position, an der die Belichtung fortgesetzt werden soll, zu einem Fehler.

Beim erfindungsgemäßen Verfahren wird zusätzlich zu den eingangs genannten Verfahrensschritten die Istanzahl der in einem Bezugsarbeitszyklus ausgeführten Bearbeitungsschritte automatisch erfasst. Die Istanzahl der in einem dem Bezugsarbeitszyklus folgenden Arbeitszyklus ausgeführten Bearbeitungsschritte wird ebenfalls automatisch erfasst. Abhängig von der Istanzahl in dem Bezugsarbeitszyklus und abhängig von der Istanzahl in dem folgenden Arbeitszyklus wird eine Prüfung auf Fertigungsfehler ausgeführt.

Die Bedienperson muss bei einem vorzeitig abgebrochenen Bearbeitungszyklus bereits im folgenden Bearbeitungszyklus die fehlenden Bearbeitungsschritte auf dem nur teilweise bearbeiteten Halbzeug ausführen, um Fehlermeldungen zu vermeiden. Das unvollständig bearbeitete Halbzeug muss demzufolge sofort nach der Wiederinbetriebnahme der Anlage bearbeitet werden. Dies verhindert, dass aufgrund einer längeren Zeitdauer zwischen dem erstmaligen Bearbeiten eines Halbzeuges und dem vollständigen Bearbeiten des Halbzeuges zusätzliche Bedienfehler entstehen.

Zum automatischen Erfassen der Anzahl von Bearbeitungsschritten wird beispielsweise der Zählerstand eines Schrittzählers in der die Bearbeitung ausführenden Anlage ausgelesen. Durch das automatische Auslesen des Zählerstandes und das automatische Prüfen wird die Bedienperson nicht mit zusätzlichen Arbeitsgängen belastet.

Durch die beim erfindungsgemäßen Verfahren verwendeten auf die Anzahl der Bearbeitungsschritte bezogenen Eingangsgrößen für die Prüfung lässt sich das Verfahren unter Durchführung einfacher Rechenoperationen ausführen. So muss beispielsweise die Summe der Istanzahl der Bearbeitungsschritte im des Bezugsarbeitszyklus und die Summe der Istanzahl der Bearbeitungsschritte im folgenden Bearbeitungszyklus gleich der Sollanzahl sein, wenn fehlerfrei gefertigt wird. Abweichungen sind als Fehler zu werten. Bei einem Fehler wird eine Fehlernachricht für die Bedienperson erzeugt. Alternativ oder kumulativ lässt sich auch die Fertigung automatisch beeinflussen.

Die Sollanzahl lässt sich beispielsweise manuell vorgeben. Außerdem ist die Sollanzahl in einem ME-System (Manufacturing Execution System) verfügbar.

Bei einer Weiterbildung des erfindungsgemäßen Verfahrens wird für die Bearbeitungszyklen jeweils die Differenz aus Sollanzahl und Istanzahl der Bearbeitungsschritte in einem Bezugsarbeitszyklus berechnet. Alternativ wird die Differenz aus Istanzahl und Sollanzahl berechnet. Es lässt sich auch mit Betragswerten rechnen. Bei einer Differenz mit einem von 0 verschiedenen Wert, werden aufeinanderfolgende Differenzen addiert oder Subtrahiert. Abhängig vom Wert der Summe wird dann die Prüfung auf Fertigungsfehler ausgeführt. Diese Vorgehensweise ermöglicht ein einfaches Ermitteln von vollständig ausgeführten Bearbeitungszyklen, weil bei diesen Bearbeitungszyklen die Differenz den Wert 0 haben muss. Andererseits lässt sich bei einem vorzeitig abgebrochenen Bearbeitungszyklus die berechnete Differenz bei der Prüfung auf Fertigungsfehler weiter verwenden. Die Summe zweier aufeinanderfolgender Differenzen muss nämlich gleich dem Wert der Sollanzahl bzw. gleich dem negativen Wert der Sollanzahl sein.

Bei einer nächsten Weiterbildung des erfindungsgemäßen Verfahrens wird die automatische Prüfung vor dem Beenden der Bearbeitungszyklen einer vorgegebenen Anzahl von Halbzeugen einer Fertigungseinheit oder doch zumindest vor der Ausführung der nächsten Fertigungsstufe für die Halbzeuge dieser Fertigungseinheit ausgeführt. Diese Vorgehensweise ermöglicht es, die Bearbeitung der Fertigungseinheit beim Auftreten eines Fehlers abzubrechen, der ohnehin dazu führt, dass der aktuelle Bearbeitungszyklus nochmals ausgeführt werden muss oder dass die gesamte Fertigungseinheit vorsichtshalber nicht mehr weiterbearbeitet wird. Die Ausnutzung der Bearbeitungsanlagen lässt sich durch diese Vorgehensweise erhöhen. Wird die automatische Prüfung vor dem Ausführen einer folgenden Bearbeitungsstufe eines Halbzeuges ausgeführt, so lässt sich bereits die folgende Bearbeitung abhängig vom Prüfergebnis beeinflussen.

Beim Auftreten eines Fehlers werden bei einer Ausgestaltung Maßnahmen zum Wiederholen der Bearbeitungszyklen für das fehlerhafte Halbzeug und/oder für die Halbzeuge der Fertigungseinheit ausgeführt, die das fehlerhafte Halbzeug enthält.

Bei einer nächsten Weiterbildung wird während der Bearbeitung in einem Bearbeitungszyklus eine Siliziumscheibe in aufeinanderfolgenden Belichtungsschritten abschnittsweise belichtet. Dabei wird die gleiche Belichtungsmaske für die Belichtungsschritte eingesetzt. Die Maske enthält Strukturen für einen oder für mehrere integrierte Schaltkreise. Insbesondere der Belichtungsprozess gestattet es, eine Nachbearbeitung einer fehlerhaft belichteten Siliziumscheibe auszuführen, wenn der Fehler unmittelbar nach der Belichtung und noch vor dem anschließenden Ätzen erfasst wird. Wird der Fehler frühzeitig, beispielsweise vor dem Ätzen, erkannt, so wird die Fotolackschicht vom Halbzeug wieder entfernt. Anschließend wird neuer Fotolack aufgebracht und die Belichtung wiederholt.

Aber auch bei Prüfschritten lässt sich das erfindungsgemäße Verfahren mit großem Nutzen einsetzen. Während eines Bearbeitungszyklus werden auf einer Siliziumscheibe aufgebrachte Schaltkreisen in aufeinanderfolgenden Prüfschritten geprüft. Die Prüfschritte sind beispielsweise Wiederholungen des gleichen Verfahrens zum Prüfen eines oder mehrerer Schaltkreise. Wird das Auslassen von Prüfschritten vor dem Vereinzeln der Schaltkreise erfasst, so kann der Prüfzyklus erneut ausgeführt werden, um sicherzustellen, dass nur fehlerfreie Schaltkreise hergestellt werden. Nach dem Vereinzeln ist es nämlich nicht mehr möglich, die nicht geprüften Schaltkreise zu ermitteln. Die Prüfung der einzelnen Schaltkreise ist nach dem Vereinzeln erheblich schwieriger als das Prüfen des Halbzeuges. So müssen die Schaltkreise aufwendiger für das Prüfen positioniert werden.

Das erfindungsgemäße Verfahren lässt sich separat für jeweils eine die Bearbeitungsschritte ausführende Anlage durchführen. Ein die Anlagen verknüpfendes Datennetz wird in diesem Fall nicht benötigt.

Alternativ werden mindestens zwei Überwachungsverfahren für zwei gleichartig oder voneinander verschieden aufgebaute Anlagen auf einer Datenverarbeitungsanlage ausgeführt, die mit den Anlagen vorzugsweise über ein lokales Datenübertragungsnetz verbunden ist. Durch diese Maßnahme lässt sich die Datenverarbeitungsanlage sehr effektiv nutzen. Als Datenübertragungsnetz wird beispielsweise ein Ethernet eingesetzt, d.h. ein Netz, mit dessen Hilfe mehrere hundert Meter überbrückbar sind. Beim Nutzen eines Datenübertragungsnetzes lässt sich an eine Bedienperson leicht eine Fehlermeldung über das Datenübertragungsnetz übertragen, z.B. als sogenanntes eMail.

Die Erfindung betrifft außerdem ein Programm mit einer Befehlsfolge, bei deren Ausführung durch einen Prozessor das erfindungsgemäße Verfahren oder eine seiner Weiterbildungen ausgeführt wird. Weiterhin betrifft die Erfindung eine Datenverarbeitungsanlage mit einem solchen Programm, d.h. beim Betrieb der Datenverarbeitungsanlage wird das erfindungsgemäße Verfahren oder eine seiner Weiterbildungen ausgeführt. Damit gelten die oben genannten technischen Wirkungen auch für das Programm und die Datenverarbeitungsanlage. Das Programm und die Datenverarbeitungsanlage sind Bestandteile eines sogenannten APC-Systems (Advanced Process Control System).

Außerdem betrifft die Erfindung eine Bearbeitungsanlage zur Herstellung von integrierten Schaltkreisen. Die Bearbeitungsanlage ist so aufgebaut, dass sie zur Ausführung des erfindungsgemäßen Verfahrens oder einer seiner Weiterbildungen geeignet ist. Insbesondere erfasst die Bearbeitungsanlage automatisch die für die Prüfung benötigte Istanzahl der Bearbeitungsschritte bzw. die Istzyklenanzahl. Auch für die Bearbeitungsanlage gelten die oben genannten technischen Wirkungen.

Im Folgenden werden Ausführungsbeispiele der Erfindung an Hand der beiliegenden Zeichnungen erläutert. Darin zeigen:
- Figur 1: Verfahrensschritte zur Überwachung der Belichtung von Siliziumscheiben, und
- Figur 2: eine Darstellung von während der Belichtung erfassten Daten und aus diesen Daten zur Überwachung ermittelten Daten.

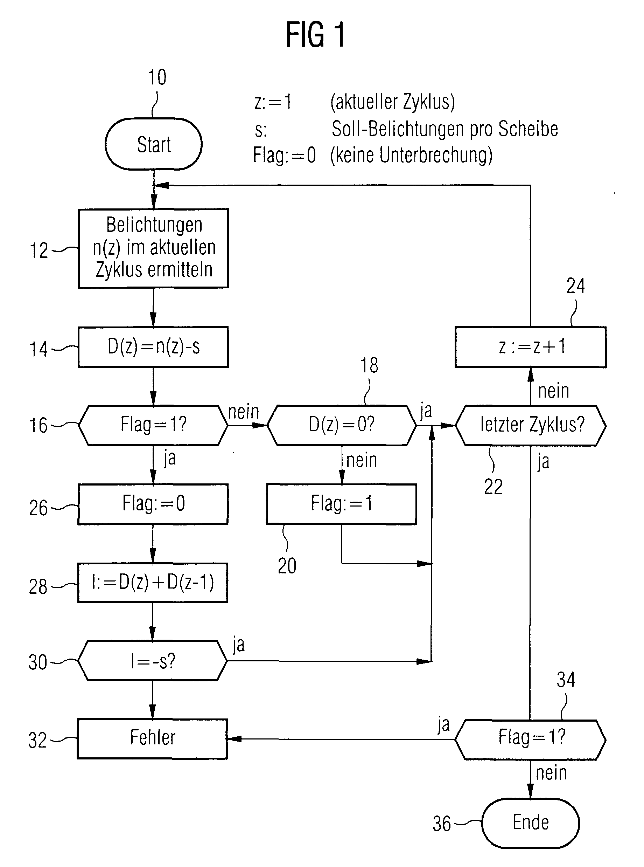

Figur 1 zeigt Verfahrensschritte zum Überwachen der Belichtung von Siliziumscheiben. Die Belichtung der Siliziumscheiben wird unter Einsatz üblicher Belichtungsverfahren ausgeführt. Zur Steuerung wird ein sogenanntes APC-System (Advanced Process Control System) genutzt, das einen zentralen Rechner enthält, der die Fertigungen auf mehreren Belichtungsanlagen überwacht. Außerdem überwacht der Rechner der Belichtung vorangehende und der Belichtung folgende Fertigungsstufen. Der zentrale Rechner ist mit den Anlagen über ein lokales Datenübertragungsnetz verbunden. Außerdem hat der zentrale Rechner Zugriff auf die Daten eines sogenannten ME-Systems (Manufacturing Execution System), mit dessen Hilfe die Herstellung der integrierten Schaltkreise logistisch begleitet wird. Die in Figur 1 dargestellten Verfahrensschritte werden auf dem zentralen Rechner des APC-Systems ausgeführt.

Bei der Erläuterung des Verfahrens werden die folgenden Abkürzungen verwendet:
N: die Anzahl der Siliziumscheiben (wafer), die eine Fertigungseinheit bilden, z.B. ein sogenanntes Los mit 50 Siliziumscheiben mit dem Durchmesser von jeweils 6 Zoll. Gegebenenfalls wurden schon Siliziumscheiben aussortiert, so dass ein Los auch weniger als 50 Siliziumscheiben enthalten kann.
n: die im aktuell betrachteten Belichtungszyklus ausgeführten Belichtungen.
m: die in einem vor einer Unterbrechung liegenden Belichtungszyklus ausgeführten Belichtungen.
k: die in einem Belichtungszyklus nach der Unterbrechung ausgeführten Belichtungen.
s: die Anzahl der Soll-Belichtungen pro Siliziumscheibe und damit die Anzahl der Belichtungen in einem vollständigen Bearbeitungszyklus.
1: die Summe der Belichtungen in den Zyklen vor und nach der Unterbrechung.
z: eine natürliche Zahl zur Bezeichnung des aktuellen Zyklus.
D: eine Differenz zur Angabe der in einem folgenden Bearbeitungszyklus auszuführenden bzw. der in einem vorhergehenden Bearbeitungszyklus ausgeführten Belichtungen.

Das Überwachungsverfahren beginnt in einem Verfahrensschritt 10. Bei einem ersten Ausführungsbeispiel wird das Verfahren durchgeführt, nachdem eine Fertigungseinheit belichtet worden ist. Die während der Belichtung erfassten Daten wurden in einer Speichereinheit des zentralen Rechners gespeichert. Die Auswertung wird mit den Daten des ersten Belichtungszyklus z = 1 begonnen. Die Anzahl der Soll-Belichtungen s pro Siliziumscheibe ist bekannt, beispielsweise sollen s=86 Belichtungen pro Siliziumscheibe ausgeführt werden. Eine Variable Flag wird auf den Wert Null gesetzt, um anzuzeigen, dass für die zu überwachende Fertigungseinheit bisher keine Unterbrechung des Belichtungsprozesses erfasst worden ist.

In einem dem Verfahrensschritt 10 unmittelbar folgenden Verfahrensschritt 12 werden die in aktuell bearbeiteten Zyklus z ermittelten Belichtungen n(z) durch Lesen der entsprechenden Daten aus der Speichereinheit ermittelt. In einem nächsten Verfahrensschritt 14 wird eine Differenz D(z) gebildet, indem die Anzahl der Soll-Belichtungen s von der Anzahl der Belichtungen im aktuell bearbeiteten Belichtungszyklus subtrahiert wird. Das Ergebnis wird im Speicher des zentralen Rechners gespeichert.

In einem dem Verfahrensschritt 14 folgenden Verfahrensschritt 16 wird geprüft, ob die Variable Flag den Wert Eins hat. Beim ersten Zyklus z = 1 ist dies noch nicht der Fall. Deshalb folgt unmittelbar nach dem Verfahrensschritt 16 ein Verfahrensschritt 18, in welchem geprüft wird, ob die im Verfahrensschritt 14 zuletzt ermittelte Differenz D(z) den Wert Null hat. Ist die Differenz ungleich Null, so folgt nach dem Verfahrensschritt 18 ein Verfahrensschritt 20, in welchem die Variable Flag auf den Wert Eins gesetzt wird, um anzuzeigen, dass ein abgebrochener Bearbeitungszyklus erfasst worden ist. Anschließend wird das Verfahren in einem Verfahrensschritt 22 fortgesetzt.

Der Verfahrensschritt 22 folgt auch unmittelbar nach dem Verfahrensschritt 18, wenn festgestellt wird, dass die Differenz D(z) den Wert Null hat. Im Verfahrensschritt 22 wird beispielsweise anhand der von der Belichtungsanlage gesendeten Datenmenge ermittelt, ob bereits die Daten des letzten Bearbeitungszyklus der aktuell zu prüfenden Fertigungseinheit überprüft worden ist. Wurde der letzte Bearbeitungszyklus noch nicht geprüft, so folgt unmittelbar nach dem Verfahrensschritt 22 ein Verfahrensschritt 24, in welchem die Zählvariable z für den aktuellen Zyklus um den Wert Eins erhöht wird. Anschließend wird das Verfahren wieder im Verfahrensschritt 12 fortgesetzt.

Im Verfahrensschritt 12 wird nun die Anzahl der Belichtungen im folgenden Bearbeitungszyklus ermittelt. Anschließend wird im Verfahrensschritt 14 eine neue Differenz D(z) aus der eben im Verfahrensschritt 12 ermittelten Belichtungen und der Anzahl der Soll-Belichtungen s gebildet. Die im Verfahrensschritt 14 berechnete Differenz D(z) wird gespeichert.

Bei der Prüfung im Verfahrensschritt 16 wird festgestellt, dass die Variable Flag nun den Wert Eins hat. Deshalb folgt nach dem Verfahrensschritt 16 ein Verfahrensschritt 26, in welchem der Wert der Variable Flag wieder auf den Wert Null gesetzt wird, um anzuzeigen, dass die Unterbrechung durch das Ausführen der nachfolgenden Verfahrensschritte geprüft worden ist.

Anschließend wird in einem Verfahrensschritt 28 die Summe 1 der beiden zuletzt ermittelten Differenzen D(z) und D(z-1) ermittelt.

In einem Verfahrensschritt 30 wird geprüft, ob die Summe 1 mit der negativen Anzahl, d.h. der mit einem negativen Vorzeichen versehenen Anzahl, der Soll-Belichtungen s übereinstimmt. Ist dies der Fall, so muss davon ausgegangen werden, dass die Bedienperson die Bearbeitung nach dem Auftreten einer Unterbrechung ordnungsgemäß fortgesetzt hat. Es gilt dann 1=m+k. Deshalb wird das Verfahren nach dem Verfahrensschritt 30 in dem oben bereits erläuterten Verfahrensschritt 22 mit der Überprüfung fortgesetzt, ob Daten eines weiteren Bearbeitungszyklus zu prüfen sind. Wird dagegen im Verfahrensschritt 30 festgestellt, dass die Summe l ungleich der negativen Anzahl der Soll-Belichtungen s ist, so folgt unmittelbar nach dem Verfahrensschritt 30 ein Verfahrensschritt 32, in welchem eine Fehlernachricht an die Bedienperson der Belichtungsanlage gesendet wird. Die Bedienperson markiert daraufhin die betrachtete Fertigungseinheit als fehlerhaft.

Wird im Verfahrensschritt 22 festgestellt, dass die Daten des letzten Bearbeitungszyklus überprüft worden sind, so folgt unmittelbar nach dem Verfahrensschritt 22 ein Verfahrensschritt 34. Im Verfahrensschritt 34 wird geprüft, ob die Variable Flag den Wert Eins hat. Ist dies der Fall, so wurde die Bearbeitung der letzten Siliziumscheibe unterbrochen. Dem Verfahrensschritt 34 folgt in diesem Fall der Verfahrensschritt 32, in welchem die Fehlermeldung erzeugt wird. Wird dagegen im Verfahrensschritt 34 festgestellt, dass die Variable Flag den Wert Null hat, so folgt unmittelbar nach dem Verfahrensschritt 34 ein Verfahrensschritt 36, in dem die Überprüfung der Fertigungseinheit beendet wird.

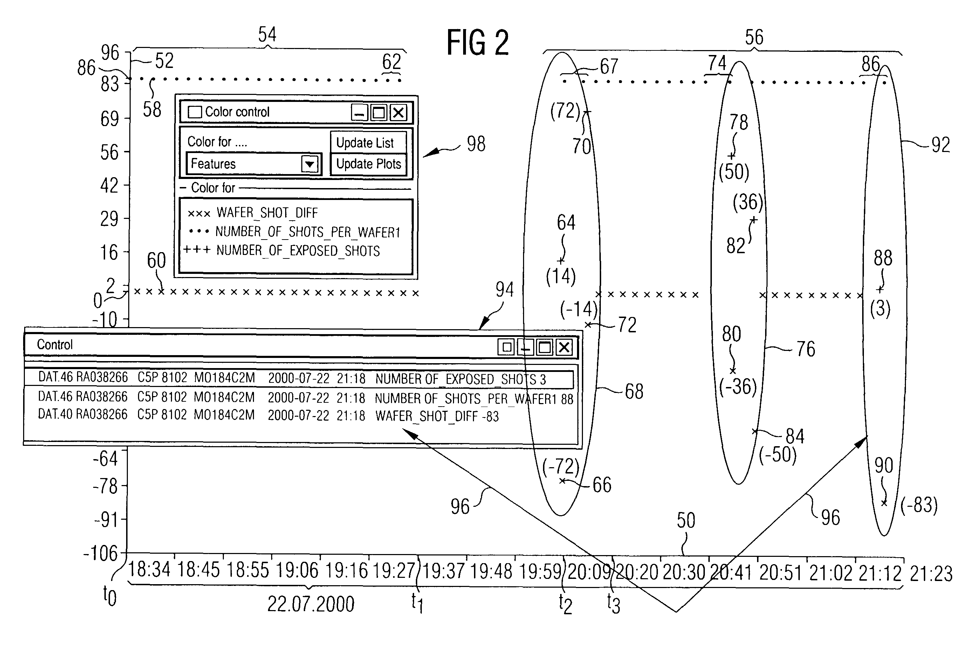

Figur 2 zeigt die Darstellung von Daten, die während der Belichtung eines Fertigungsloses erfasst worden sind, das 46 Siliziumscheiben in zwei Fertigungshorden mit jeweils 23 Siliziumscheiben enthielt. Ein Fertigungslos bildet eine Transporteinheit beim Transportieren der Scheiben zu den Anlagen. Eine Fertigungshorde bildet eine Beschickungseinheit beim Beschicken der Anlagen. Die genannten Zahlen gelten für 6-Zoll Siliziumscheiben. Auf einer Abszissenachse 50 ist das Datum und die Fertigungszeit abgetragen. Eine Ordinatenachse 52 zeigt die Anzahl von Belichtungsschritten.

Ein Teil 54 der Darstellung betrifft die erste Horde des Loses. Die erste Horde enthält 23 Siliziumscheiben, bei deren Belichtung keine Unterbrechung aufgetreten ist. Die Belichtung der Siliziumscheiben der ersten Horde begann zu einem Zeitpunkt t0, am 22.07.00 um 18:34. Für jede Siliziumscheibe der ersten Horde ist die Anzahl der Soll-Belichtungen durch Punkte dargestellt, siehe beispielsweise Punkt 56 für die dritte Siliziumscheibe der ersten Horde. Es sind jeweils 86 Belichtungen für jede der 23 Siliziumscheiben der ersten Horde ausgeführt worden. Die im Verfahrensschritt 14 berechneten Differenzen haben alle den Wert Null und sind durch Kreuze dargestellt, vgl. beispielsweise das Kreuz 60 für die dritte Siliziumscheibe der ersten Horde. Eine Klammer 62 zeigt die Prozesszeit zum Belichten einer Siliziumscheibe, für den Fall, dass keine Unterbrechung auftritt. Die Bearbeitungszeit für eine Siliziumscheibe beträgt etwa 2 ½ Minuten. Die Bearbeitung der ersten Horde wird zu einem Zeitpunkt t1 beendet. Die Bedienperson nimmt die erste Horde des Loses aus der Anlage und beschickt die Anlage mit der zweiten Horde. Zu einem Zeitpunkt t2 wird mit der Bearbeitung der Siliziumscheiben der zweiten Horde begonnen. Die Zeit zwischen den Zeitpunkten t1 und t2 beträgt etwa 30 Minuten.

Bei der Belichtung der ersten Siliziumscheibe der zweiten Horde tritt nach vierzehn Belichtungen eine Unterbrechung auf. Die vierzehn Belichtungen sind durch ein Kreuz dargestellt. Im Verfahrensschritt 14 wurden als Differenz -72 Belichtungen berechnet, siehe Kreuz 66. Die erste Unterbrechung 68 ist in Figur 2 durch eine Ellipse eingekreist.

Die Bedienperson beseitigt die Ursache für die Unterbrechung 68 und startet die Anlage zu einem Zeitpunkt t3 erneut. Zum Beseitigen der Unterbrechung werden etwa 3 Minuten benötigt. Damit ist die Bearbeitungszeit zum Belichten der ersten Siliziumscheibe wesentlich länger als die Bearbeitungszeit bei ununterbrochener Belichtung, nämlich um mehr als das Doppelte, siehe Klammer 67.

Im nächsten Bearbeitungszyklus sind 72 Belichtungen ausgeführt worden, siehe Pluszeichen 70. Es ist zu Vermuten, dass die Bedienperson richtig das Belichten mit derselben Siliziumscheibe wie im vorhergehenden Bearbeitungszyklus veranlasst hat. Die im Verfahrensschritt 14 berechnete Differenz D beträgt -14, siehe Kreuz 72. Die Summe der für den ersten Bearbeitungszyklus und für den zweiten Bearbeitungszyklus berechneten Differenzen D beträgt -86, so dass im Verfahrensschritt 30 festgestellt wird, dass die Summe gleich dem negativen Wert der Sollanzahl s ist. Ein Bedienfehler liegt also bei der Fortsetzung des Belichtens nach der Unterbrechung 68 nicht vor.

Die folgenden Siliziumscheiben der zweiten Horde sind ohne Unterbrechung belichtet worden. Nach dem zwölften Bearbeitungszyklus, d.h. auf Grund der Unterbrechung 68 bei der Bearbeitung der elften Siliziumscheibe der zweiten Horde, trat eine Unterbrechung auf, siehe Klammer 74. Diese Unterbrechung wird durch das oben an Hand der Figur 1 erläuterte Verfahren nicht erfasst, da sie nach der Ausführung eines vollständigen Bearbeitungszyklus, d.h. nach der Ausführung von 86 Belichtungen aufgetreten ist. Bei solchen Unterbrechungen treten jedoch in der Regel keine Bedienfehler auf, weil die Bedienperson die Bearbeitung mit einer noch nicht belichteten Siliziumscheibe fortsetzt.

Bei der Belichtung der folgenden Siliziumscheibe ist eine Unterbrechung 76 aufgetreten, die in Figur 2 durch eine Ellipse eingekreist ist. Es sind nur 50 Belichtungen ausgeführt worden, siehe Pluszeichen 78. Die im Verfahrensschritt 14 für die Daten des aktuell zu prüfenden Belichtungszyklus ermittelte Differenz D beträgt -36, siehe Kreuz 80. Nach der Unterbrechung 78 sind im folgenden Belichtungszyklus 36 Belichtungen ausgeführt worden, siehe Pluszeichen 82. Die im Verfahrensschritt 14 berechnete Differenz D beträgt -50, siehe Kreuz 84. Die im Verfahrensschritt 30 berechnete Summe der zuletzt berechneten Differenzen D ist gleich dem negativen Wert der Anzahl von Soll-Belichtungen s, d.h. gleich -86. Ein Bedienfehler liegt somit aller Wahrscheinlichkeit bei der Fortsetzung des Belichtens nicht vor.

Die folgenden Siliziumscheiben sind dann bis zur vorletzten Siliziumscheibe unterbrechungsfrei belichtet worden. Vor dem Belichten der letzten Siliziumscheibe ist eine Unterbrechung aufgetreten, siehe Klammer 86. Diese Unterbrechung 86 trat jedoch nach einem Belichtungszyklus mit 86 Belichtungen auf, so dass Bedienfehler nicht zu erwarten sind. Für die letzte Siliziumscheibe des Loses sind drei Belichtungen ausgeführt worden, siehe Pluszeichen 88. Die im Verfahrensschritt 14 ermittelte Differenz D beträgt -83, siehe Kreuz 90. Aufgrund der Differenz D von -83 wird nach dem Verfahrensschritt 18 der Verfahrensschritt 20 ausgeführt und eine Unterbrechung 92 erfasst, die in Figur 2 durch eine Ellipse dargestellt ist. Im Verfahrensschritt 34 wird aufgrund der Unterbrechung 92 bei der Bearbeitung der letzten Siliziumscheibe ein Bedienfehler gemeldet. Es fehlen nämlich 83 Belichtungen.

Aufgrund des Fehlers wird der Bedienperson der Belichtungsanlage eine eMail geschickt, deren Inhalt in einem Fenster 94 dargestellt ist. Die eMail enthält drei Zeilen, in denen angegeben ist, dass drei Belichtungen ausgeführt worden sind, dass 86 Belichtungen auszuführen waren und dass somit noch 83 Belichtungen auszuführen sind. Außerdem enthält die eMail die Anzahl der Siliziumscheiben im Los, d.h. 46, das Datum, die Uhrzeit und weitere Angaben zur Fertigung. Pfeile 96 deuten den Zusammenhang der Unterbrechung 92 und der im Fenster 94 dargestellten eMail an.

In einem Fenster 98 wird eine Legende dargestellt, die die Zuordnung der Kreuze, der Punkte bzw. der Pluszeichen zu den Differenzwerten, zu der Sollanzahl von Belichtungen bzw. zu der tatsächlich ausgeführten Anzahl von Belichtungen angibt.

Bei einem anderen Ausführungsbeispiel wird die Auswertung der Prozessdaten bereits am Ende der Belichtung der Siliziumscheiben einer Horde ausgeführt. Bei einem nächsten Ausführungsbeispiel werden die Prozessdaten unmittelbar nach dem Ausführen eines Prozesszyklus ausgewertet. Damit kann ein Bedienfehler innerhalb von zwei Bearbeitungszyklen erfasst werden.

## Patentansprüche

1. Verfahren zum automatischen Überwachen der Herstellung von integrierten Schaltkreisen,
bei dem die Sollanzahl (s) von Bearbeitungsschritten für einen Bearbeitungszyklus (z) vorgegeben wird, in welchem ein Halbzeug bearbeitet oder geprüft wird, aus dem mehrere integrierte Schaltkreise gefertigt werden,
bei dem die Istanzahl (n(z-1)) der in einem Bezugsarbeitszyklus (z-1) ausgeführten Bearbeitungsschritte automatisch erfasst wird,
die Istanzahl (n(z)) der in einem dem Bezugsarbeitszyklus (z-1) folgenden Arbeitszyklus (z) ausgeführten Bearbeitungsschritte automatisch erfasst wird,
und bei dem abhängig von der Istanzahl (n(z-1)) in dem Bezugsarbeitszyklus (z-1) und abhängig von der Istanzahl (n(z)) in dem folgenden Arbeitszyklus (z) automatisch eine Prüfung auf Fertigungsfehler ausgeführt wird.

2. Verfahren nach Anspruch 1, **dadurch gekennzeichnet, dass** für die Bearbeitungszyklen jeweils die Differenz (D(z), D(z-1)) aus Sollanzahl (s) und Istanzahl (n) der Bearbeitungsschritte oder die Differenz ((D(z)),D(z-1)) aus Istanzahl (n) und Sollanzahl (s) berechnet wird,
dass bei einer Differenz (D(z-1)) mit einem von Null verschiedenen Wert diese Differenz (D(z-1)) und eine für den folgenden Bearbeitungszyklus (z) ermittelte Differenz (D(z)) addiert-oder subtrahiert werden,
und dass abhängig vom Wert der Summe oder Differenz die Prüfung auf einen Fertigungsfehler ausgeführt wird.

3. Verfahren nach Anspruch 1 oder 2, **dadurch gekennzeichnet, dass** die automatische Prüfung vor dem Beenden der Bearbeitungszyklen einer vorgegebenen Anzahl von Halbzeugen einer Fertigungseinheit, vorzugsweise einer Horde oder eines Loses, und/oder vor dem Ausführen einer folgenden Bearbeitungsstufe eines Halbzeuges ausgeführt wird,
und dass die weitere Fertigung des Halbzeuges abhängig vom Prüfergebnis gelenkt wird,
wobei beim Auftreten eines Fehlers vorzugsweise Maßnahmen zur Wiederholung eines Bearbeitungszyklus für das fehlerhafte Halbzeug und/oder für die Halbzeuge einer das fehlerhafte Halbzeug enthaltenen Fertigungseinheit ausgeführt werden.

4. Verfahren nach einem der vorhergehenden Ansprüche, **dadurch gekennzeichnet, dass** während der Bearbeitung in einem Bearbeitungszyklus eine Siliziumscheibe in aufeinanderfolgenden Belichtungsschritten flächenabschnittsweise belichtet oder auf einer Siliziumscheibe aufgebrachte Schaltkreise in aufeinanderfolgenden Prüfschritten geprüft werden.

5. Verfahren nach einem der vorhergehenden Ansprüche, **dadurch gekennzeichnet, dass** das Verfahren separat für eine die Bearbeitungsschritte ausführende Anlage durchgeführt wird.

6. Verfahren nach einem der Ansprüche 1 bis 4, **dadurch gekennzeichnet, dass** mindestens zwei Überwachungsverfahren für zwei Anlagen auf einer Datenverarbeitungsanlage ausgeführt werden, die mit den Anlagen vorzugsweise über ein lokales Datenübertragungsnetz verbunden ist,
und dass vorzugsweise eine Nachricht an eine Bedienperson als Fehlermeldung über das Datenübertragungsnetz gesendet wird.

7. Verfahren nach einem der vorhergehenden Ansprüche, **dadurch gekennzeichnet, dass** beim Erfassen eines Fertigungsfehlers eine Fehlermeldung erzeugt und/oder automatisch eine Fehlerbeseitigung veranlasst wird.

8. Programm mit einer Befehlsfolge, bei deren Ausführung durch einen Prozessor ein Verfahren nach einem der vorhergehenden Ansprüche ausgeführt wird.

9. Datenverarbeitungsanlage, **dadurch gekennzeichnet, dass** die Datenverarbeitungsanlage so aufgebaut ist, dass bei ihrem Betrieb ein Verfahren nach einem der Ansprüche 1 bis 7 ausgeführt wird.

10. Bearbeitungsanlage zur Herstellung von integrierten Schaltkreisen, **dadurch gekennzeichnet, dass** die Bearbeitungsanlage so aufgebaut ist, dass sie zur Ausführung des Verfahrens nach einem der Ansprüche 1 bis 7 geeignet ist.
